# EUROPÄISCHE PATENTANMELDUNG

(11) **EP 1 860 777 A2**
(43) Veröffentlichungstag der Anmeldung: **28.11.2007**
(21) Anmeldenummer: 07009764.7
(22) Anmeldetag: 16.05.2007
(51) Int. Cl.: H03K 17/96

(54) **Sensorelement-Anordnung für eine Bedieneinrichtung und Verfahren zum Betrieb einer solchen Sensorelement-Anordnung**

(30) Priorität: 23.05.2006 DE 102006025069
(71) Anmelder: E.G.O. ELEKTRO-GERÄTEBAU GmbH, 75038 Oberderdingen (DE)
(72) Erfinder: Dorwarth, Ralf, Dr., 75038 Oberderdingen (DE); Schilling, Wilfried, 76703 Kraichtal (DE)
(74) Vertreter: Patentanwälte Ruff, Wilhelm, Beier, Dauster & Partner

(57) **Zusammenfassung**

Eine Sensorelementanordnung (11) unter einer Bedienoberfläche (12) weist eine Elektrolumineszenz-Folie (15) der Bedieneinrichtung eine obere Elektrode (17) und eine untere Elektrode (16) auf, die zur Ansteuerung dienen. Die obere Elektrode (17) dient zusätzlich als kapazitives Sensorelement, um das Auflegen eines Fingers (18) auf die Bedienoberfläche (12) oberhalb der Elektrolumineszenz-Folie (15) als Bedienung zu erfassen. Hierzu ist eine geeignete Ansteuer- und Auswerteschaltung (20) vorgesehen, beispielsweise mit Ansteuerung in Vollbrückenschaltung zur Erfassung eines über die obere Elektrode (17) und den Finger (18) abfließenden Sensorstroms.

## Beschreibung

### Anwendungsgebiet und Stand der Technik

Die Erfindung betrifft eine Sensorelement-Anordnung für eine Bedieneinrichtung und ein Verfahren zum Betrieb einer solchen Sensorelement-Anordnung.

Es ist beispielsweise aus der DE 103 26 684 A1 bekannt, ein kapazitives Sensorelement als leitfähige Schicht unter einer Bedienoberfläche anzuordnen. Durch geeignete Ansteuerung und Auswertung, insbesondere mit einer entsprechenden Schaltung, kann erfasst werden, ob eine Bedienung durch Auflegen eines Fingers auf die Bedienoberfläche oberhalb des Sensorelements vorliegt. Insbesondere wird nämlich zwischen Finger und Sensorelement eine Kapazität bzw. ein Kondensator gebildet, über den ein Strom abfließt, bzw. die Kapazität des Sensorelements wird vergrößert.

Bei dem vorgenannten Sensorelement ist es zwar möglich, unter dem Sensorelement eine Leuchtanzeige anzubringen, insbesondere eine Sieben-Segment-Anzeige. Der Mehraufwand für diese mehreren separaten Bauteile ist jedoch groß, insbesondere auch die entsprechende Montage.

### Aufgabe und Lösung

Der Erfindung liegt die Aufgabe zugrunde, eine eingangs genannte Sensorelement-Anordnung sowie ein Verfahren zur Auswertung eines Sensorelements zu schaffen, mit denen Probleme des Standes der Technik vermieden werden können und insbesondere auf möglichst günstige Weise ein Sensorelement und eine Leuchtanzeige kombiniert werden kann.

Gelöst wird diese Aufgabe durch eine Sensorelement-Anordnung mit den Merkmalen des Anspruchs 1 sowie ein Verfahren mit den Merkmalen des Anspruchs 8. vorteilhafte sowie bevorzugte Ausgestaltungen der Erfindung sind in den weiteren Ansprüchen angegeben und werden im Folgenden näher erläutert. Manche Merkmale werden nur für die Anordnung oder nur für das Verfahren genannt, sollen jedoch unabhängig davon für beides geltend gemacht werden kann. Der Wortlaut der Ansprüche wird durch ausdrückliche Bezugnahme zum Inhalt der Beschreibung gemacht.

Es ist vorgesehen, dass die leitfähige Schicht, die dann insbesondere das Sensorelement bildet, als kapazitives Sensorelement an einem Träger angeordnet ist. Mit diesem Sensorelement kann die Annäherung eines Fingers einer Bedienperson oder eines ähnlichen Gegenstandes erkannt werden. Erfindungsgemäß wird als Träger eine Elektrolumineszenz-Folie verwendet. Derartige Folien sind im Stand der Technik ausreichend bekannt. Eine solche Elektrolumineszenz-Folie enthält beispielsweise Phosphor für den Leuchteffekt. Durch Anlegen eines elektrischen Wechselfeldes an beiden Seiten, insbesondere über entsprechende Elektroden, wird der Leuchteffekt hervorgerufen. Eine solche Leuchtanzeige wird also erfindungsgemäß als Träger mit einem Sensorelement, insbesondere dem vorgenannten kapazitiven Sensorelement, kombiniert.

Die als Sensorelement fungierende leitfähige Schicht bildet bei Annähern eines Fingers oder Gegenstandes, insbesondere bei Auflegen auf eine Bedienoberfläche der Bedieneinrichtung über dem Sensorelement, eine Kapazität bzw. einen Kondensator. Eine Bedienoberfläche kann beispielsweise eine Bedienblende, eine Gehäusewand eines Elektrogerätes oder aber auch eine Glaskeramikkochfläche eines Kochfeldes sein.

Bei einer Ausgestaltung der Erfindung ist die leitfähige Schicht auf der Oberseite der Elektrolumineszenz-Folie vorgesehen bzw. auf der Seite, die einer Bedienoberfläche wie beispielsweise einer Blende oder Gehäuseseite oder -wand zugewandt ist. So ist die Funktion als Sensorelement besonders gut.

In nochmals weiterer Ausgestaltung der Erfindung ist die leitfähige Schicht eine der Elektrodenschichten der Elektrolumineszenz-Folie, vorteilhaft eine obere. Dazu ist sie lichtdurchlässig bzw. durchsichtig, insbesondere aus ITO. Sie kann zur Darstellung unterschiedlicher Zeichen oder Symbole ausgebildet sein bzw. entsprechend strukturiert sein, also die Formen der Zeichen oder Symbole aufweisen. Die Leuchterscheinung an der Elektrolumineszenz-Folie wird dann durch die Form dieser Elektrode vorgegeben. Dabei können auf einer Elektrolumineszenz-Folie mehrere Sensorelemente bzw. vorgenannte leitfähige Schichten vorgesehen sein, die nebeneinander bzw. mit Abstand angeordnet sind. Dies weist den Vorteil auf, dass, insbesondere bei Ausbildung als Bedieneinrichtung, im Wesentlichen nur eine einzige Folie verarbeitet bzw. eingebaut werden muss, an der dann mehrere Sensorelemente vorhanden sind.

Zumindest eine der Bedienoberfläche zugewandte Elektrode bzw. Elektrodenschicht der Elektrolumineszenz-Folie kann über Schaltmittel mit einer Auswerteschaltung verbunden sein. Eine Ansteuerung erfolgt über eine Ansteuerschaltung, insbesondere an die andere Elektrode bzw. die als Sensorelement fungierende leitfähige Schicht. Es ist möglich, dass die Ansteuerschaltung und die Auswerteschaltung eine kombinierte Ansteuer- und Auswerteschaltung bilden. Insbesondere können mit einer derartigen Schaltung mehrere gleichartige Sensorelemente betrieben werden, insbesondere an der gleichen Elektrolumineszenz-Folie.

Gemäß einer Ausgestaltung der Erfindung kann eine Auswerteschaltung einen Stromspiegel bzw. eine Stromspiegelschaltung aufweisen. Diese Stromspiegelschaltung spiegelt den über die leitfähige Schicht und einen angelegten Finger abfließenden Strom in einen Sammel-Kondensator, wo er erfasst wird als Maß für den abfließenden Strom. Bei Über- oder Unterschreiten eines Schwellwertes wird eine Bedienung erkannt oder eben nicht. Eine hierzu verwendete mögliche Schaltung wird später erläutert.

Gemäß einer anderen Ausgestaltung ist in der Ansteuer- und Auswerteschaltung eine Vollbrückenschaltung für das Sensorelement bzw. die Elektrolumineszenz-Folie vorgesehen. Mit dieser wird zeitweise nur die leitfähige Schicht mit einer pulsierenden Wechselspannung versorgt, wobei der zweite Zweig der Brückenschaltung hochohmig geschaltet ist. Mit einer geeigneten Schaltung, beispielsweise entsprechend der DE 103 03 480 A1, kann der Sensorstrom gemessen werden. Dazu kann beispielsweise in jeder 10. Periode der Wechselspannung die zweite Hälfte der Brücke hochohmig geschaltet werden, wobei die erste Hälfte der Brücke mit einer höheren Frequenz betrieben wird. Auch eine hierzu verwendete mögliche Schaltung wird später erläutert.

Die Erfindung benutzt in einer Ausgestaltung eine elektronische Schaltung, welche die der Bedienoberfläche abgewandte Elektrode der Elektrolumineszenz-Folie in jeder Schwingungsperiode der Betriebsspannung für eine kurze Zeit vom Generator der Betriebsspannung abtrennt. In dieser kurzen Zeit fließt im wesentlichen nur der Sensorstrom, der durch das elektrische Feld gegen die Umgebung bzw. den Bediener abgeleitet wird. In dieser kurzen Zeit kann also der Sensorstrom gemessen und ausgewertet werden, insbesondere hinsichtlich einer möglichen Bedienung, wie dies von kapazitiven Sensorelementen ja allgmein bekannt ist.

Die Erfindung soll im Prinzip die Vorteile der kapazitiven Sensortechnik und der Elektrolumineszenz-Folien dadurch vereinen, dass die Elektrolumineszenz-Folie bzw. eine ihrer Elektroden, die für die Ansteuerung vorgesehen sind, als kapazitiver Sensor benutzt wird. Dazu ist es notwendig, ein elektrisches Feld zwischen dem der Bedienoberfläche zugewandten Pol der Elektrolumineszenz-Folie und einem betätigenden bzw. auf die Bedienoberfläche aufgelegten Finger auszuwerten. Da eine Elektrolumineszenz-Folie mit einer relativ hohen Wechselspannung von etwa 100V mit einer Frequenz von 400-2000 Hz betrieben wird, fließt bei Annäherung eines Fingers an die Bedienoberfläche bzw. die Oberfläche der Folie ein durch das elektrische Feld verursachter Strom über die Bedienperson gegen Erde ab. Dieser Strom kann zur Realisierung eines kapazitiven Sensors ausgewertet werden. Da der Strom sehr klein ist und innerhalb der Ansteuerelektronik nur als Summenstrom zusammen mit dem Betriebsstrom der Elektrolumineszenz-Folie fließt, kann der Sensorstrom vom Leuchtstrom nur schwer unterschieden werden, vor allem, weil die Bedieneinrichtung sowohl im leuchtenden als auch im nicht leuchtenden Zustand Elektrolumineszenz-Folie funktionieren muss.

Die Erfindung soll die Vorteile der kapazitiven Sensortechnik und der EL-Folien dadurch vereinigen, dass die EL-Folie als kapazitiver Sensor benutzt wird. Dazu ist es notwendig, das elektrische Feld zwischen dem der Tastenoberfläche zugewandten Pol der EL-Folie und dem betätigenden Finger auszuwerten. Da EL-Folien mit einer relativ hohen Wechselspannung von etwa 100V mit einer Frequenz von 400 - 2000 Hz betrieben werden, fließt bei Annäherung eines Fingers an die Oberfläche der EL-Folie ein durch das elektrische Feld verursachter Strom über die bedienende Person gegen Erde ab. Dieser Strom kann zur Realisierung einer kapazitiven Sensortaste ausgewertet werden. Da der Strom sehr klein ist und innerhalb der Ansteuerelektronik nur als Summenstrom zusammen mit dem Betriebsstrom der EL-Folie fließt, kann der Sensorstrom von Leuchtstrom nur schwer unterschieden werden. Dies umso mehr, als die Taste sowohl im leuchtenden als auch im nicht leuchtenden Zustand funktionieren muss.

Die Erfindung benutzt eine elektronische Schaltung, welche die von der Bedienoberfläche abgewandte Elektrode der EL-Folie in jeder Schwingungsperiode der Betriebsspannung für eine kurze Zeit vom Generator abtrennt. In dieser Zeit fließt im wesentlichen nur der Sensorstrom, der durch das elektrische Feld gegen die Umgebung bzw. den Bediener abgeleitet wird. In dieser Zeit kann der Sensorstrom gemessen werden.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte sowie Zwischen-Überschriften beschränken die unter diesen gemachten Aussagen nicht in ihrer Allgemeingültigkeit.

### Kurzbeschreibung der Zeichnungen

Ausführungsbeispiele der Erfindung sind in den Zeichnungen schematisch dargestellt und werden im Folgenden näher erläutert. In den Zeichnungen zeigt:
- Fig. 1: die Anordnung einer Elektrolumineszenz-Folie samt Sensorelement unter einer Bedienoberfläche;
- Fig. 2: eine Ansteuer- und Auswerteschaltung für das Sensorelement sowie die Elektrolumineszenz-Folie und
- Fig. 3: eine Abwandlung einer Ansteuer- und Auswerteschaltung von Fig. 2.

### Detaillierte Beschreibung der Ausführungsbeispiele

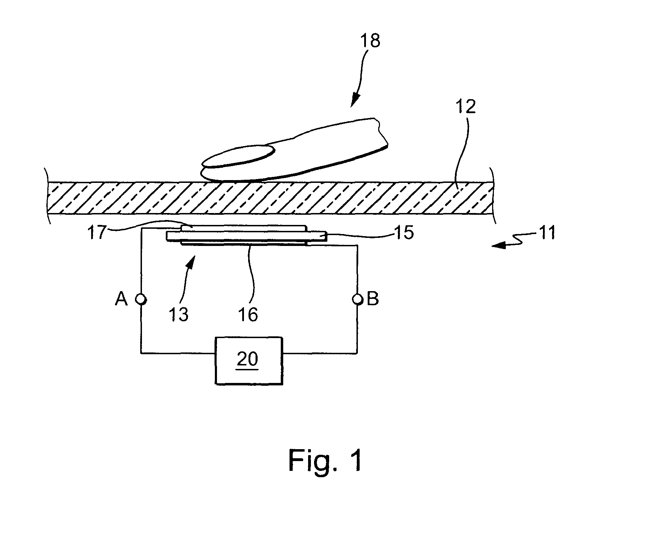

In Fig. 1 ist eine Sensorelement-Anordnung 11 dargestellt. Unter einer Bedienoberfläche 12, beispielsweise eine Kunststoffblende oder ein Glaskeramik-Kochfeld, ist eine Baueinheit 13 angeordnet mit einer Elektrolumineszenz-Folie 15, an deren Unterseite eine untere Elektrode 16 und an deren Oberseite eine obere Elektrode 17 angebracht sind. Die Elektrolumineszenz-Folie 15 ist, insbesondere zusammen mit der unteren Elektrode 16, auf an sich übliche Art und Weise aufgebaut. Die obere Elektrode 17 entspricht auch einer üblichen Ausführung, insbesondere ist sie als transparente elektrisch leitfähige Schicht ausgebildet, beispielsweise aus ITO. Von der Form bzw. flächigen Ausdehnung her kann vor allem die obere Elektrode 17 definieren, mit welcher geometrischen Form an der Elektrolumineszenz-Folie 15 ein leuchtendes Symbol durch die durchsichtige Bedienoberfläche 12 hindurch dargestellt wird. Des Weiteren bildet die obere Elektrode 17 das Sensorelement bzw. die Fläche des Sensorelements.

Die obere Elektrode 17 ist über den Anschluss A mit der im Folgenden beschriebenen Schaltung 20 verbunden und die untere Elektrode 16 mit dem Anschluss B. Unter der Bedienoberfläche 12 könnten noch weitere derartige Sensorelemente angeordnet sein, entweder an derselben Elektrolumineszenz-Folie 15 oder völlig separat davon. Jedenfalls sind die Elektroden voneinander getrennt. Auch diese weiteren Sensorelemente sind vorteilhaft mit der Schaltung 20 verbunden.

Zur Ansteuerung der Elektrolumineszenz-Folie 15 zu Anzeigezwecken wird diese mit einer relativ hohen Wechselspannung von etwa 100 V und einer mittleren Frequenz, beispielsweise zwischen 400 Hz und 2000 Hz, betrieben. Da jedoch der Strom, der über den oberhalb der oberen Elektrode 17 auf die Bedienoberfläche 12 gelegten Finger 18 abfließt, relativ klein ist und innerhalb der Ansteuerung über den Anschluss A sowie B nur als Summenstrom zusammen mit dem Betriebsstrom der Folie fließt, kann der Sensorstrom von dem für das Leuchten dienenden Strom nur schwer unterschieden werden. Dabei ist auch zu berücksichtigen, dass die Taste prinzipiell sowohl im leuchtenden als auch im nichtleuchtenden Zustand funktionieren sollte.

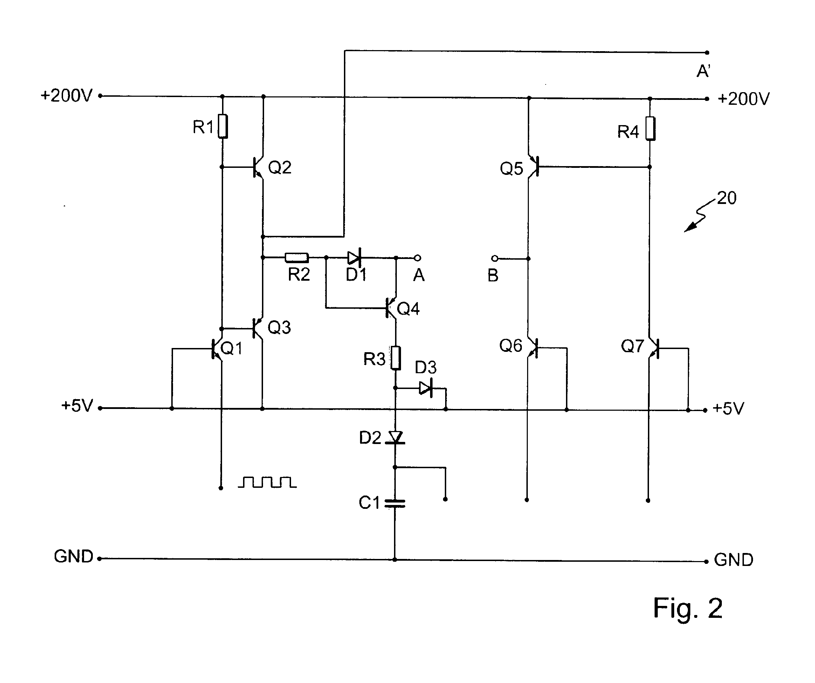

Fig. 2 zeigt eine Ansteuer- und Auswerteschaltung 20. Mit ihr ist die Elektrolumineszenz-Folie 15 bzw. die obere Elektrode 17 über den Anschluss A und die untere Elektrode A über den Anschluss B verbunden. Die Elektroden werden dabei im Ausgangszweig einer Vollbrückenschaltung bestehend aus dem ersten Zweig mit den Transistoren Q2 und Q3 einerseits und dem zweiten Zweig mit den Transistoren Q5 und Q6 andererseits betrieben. Der Vorteil dieser Schaltung ist, dass die Spannung an der Elektrolumineszenz-Folie 15 bzw. den Elektroden 16 und 17 umgepolt wird und somit eine Wechselspannung anliegt.

Zum Messen werden die Transistoren Q2 und Q3 beispielsweise mit einer Frequenz von 10 kHz betrieben und zum Leuchten bzw. als Leuchtanzeige mit einer Frequenz von 1 kHz. Die Transistoren Q5 und Q6 werden dann zum Messen ausgeschaltet und zum Leuchten im Gegentakt mit einer Frequenz von 1 kHz. Dieses Messen und Leuchten wird vorteilhaft abwechselnd gemacht, damit über einen zu erfassenden Zeitraum hinweg beide Funktionen so ausgeübt werden, dass sie für eine Bedienperson erfassbar sind. Es soll also sowohl Leuchten als auch Erfassen einer Bedienung bzw. Berührung gleichzeitig möglich sein, beispielsweise wenn eine Bedienperson einen Finger 18 zur Bedienung auf das leuchtende Bedienelement legt.

Wird also von oben den Finger 18 auf die Bedienoberfläche 12 oberhalb der Sensorelementanordnung 11 bzw. der oberen Elektrode 17 gelegt, so bildet er mit der Elektrode 17 eine Kapazität und ein Strom kann über den Finger des Benutzers abfließen. Wird zum Messen nur die obere Elektrode 17 mit einer pulsierenden Spannung versorgt, beispielsweise den genannten 10 kHz, wobei der zweite Zweig der Brücke hochohmig geschaltet und damit abgeschaltet ist, so kann mit einer geeigneten Schaltung der Sensorstrom ermittelt werden. Diese Ermittlung kann beispielsweise dadurch geschehen, dass in jeder 10. Periode der am Sensorelement bzw. der Folie 15 anliegenden Wechselspannung die zweite Hälfte der Brücke hochohmig geschaltet wird. Stattdessen wird nur der erste Zweig mit der höheren Frequenz betrieben. So kann in aus der DE 103 03 480 A1, deren Inhalt hiermit durch ausdrückliche Bezugnahme zum Inhalt der vorliegenden Beschreibung gemacht wird, bekannten Weise der Sensorstrom gemessen werden. Somit kann durch eine geeignete Auswertung eine Berührung detektiert werden, also der Fall, dass über die obere Elektrode 17 und den Finger 18 ein Strom abfließt oder nicht. In weiterer vorteilhafter Ausgestaltung der Erfindung ist ein Betrieb des zweiten Zweiges der Brücke im Gleichtakt mit den 10 kHz ebenfalls denkbar und vorteilhaft.

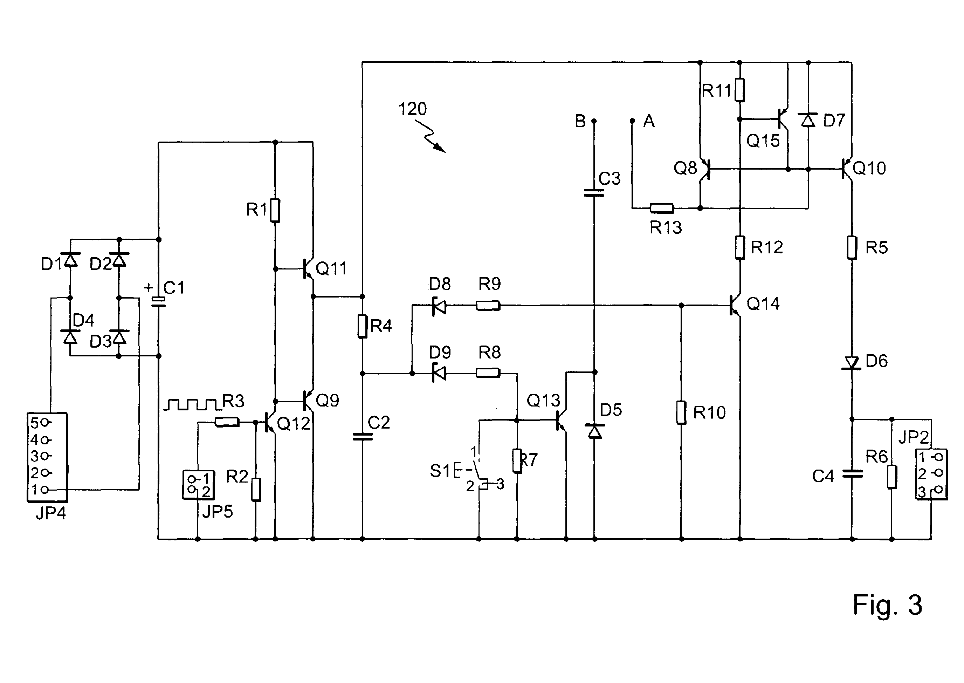

Fig. 3 zeigt eine Abwandlung einer Ansteuer- und Auswerteschaltung 120, bei der die untere Elektrode 16, die nicht für die kapazitive Berührung ausgewählt wird, für kurze Zeit abgetrennt wird, vorteilhaft in jeder Schwingungsperiode der Betriebsspannung. Diese Verzögerungs-Zeit sollte so bemessen sein, dass durch den Sensorstrom der von Elektrode 17 und Finger 18 gebildete Kondensator vollständig aufgeladen wird, beispielsweise auf 100 V. In dieser Zeit fließt dann nur der Sensorstrom, der über den Finger 18 abgeleitet wird, und der in dieser Zeit gemessen werden kann.

Über den Schalter S1 wird die Leuchtfunktion an- und ausgeschaltet. Am Widerstand R3 wird ein Rechtecksignal mit 5 V und 1 kHz eingespeist.

Die Ansteuer- und Auswerteschaltung 120 legt bei jeder positiven Flanke der Betriebsfrequenz über den Transistor Q13 die untere Elektrode 16 für einige Mikrosekunden verzögert an den Minuspol der Versorgungsspannung. In dieser Zeit fließt nur ein Strom über die obere Elektrode 17 und einen aufgelegten Finger 18. Ist der Finger 18 nicht aufgelegt, so kann dieser Strom nicht fließen.

Die Transistoren Q8 und Q10 bilden einen Stromspiegel, über den ein etwa gleich großer Strom in den Kondensator C4 fließt. Kurz bevor über Q13 die untere Elektrode 16 an die Betriebsspannung gelegt wird, schalten die Transistoren Q14 und Q15 den Stromspiegel wieder ab, sodass der anschließend fließende größere Betriebsstrom für das Leuchten der Elektrolumineszenz-Folie 15 nicht in den Kondensator C4 fließen bzw. gespiegelt werden kann. Somit werden im Kondensator C4 Strompulse gesammelt, die als Maß für den Sensorstrom herangezogen werden können. Über den Widerstand R6 wird dieser Strom abgeleitet, sodass sich je nach Größe des Stroms an R6 eine Spannung einstellt. Diese Spannung ist ein Maß für die in C4 gespeicherte Ladung, welche wiederum ein Maß dafür ist, ob der Sensorstrom über die obere Elektrode 17 und den Finger 18 fließen kann, also ob der Finger 18 aufgelegt ist und somit der Fall einer Bedienung vorliegt, oder nicht. In diesem Fall kann an R6 eine höhere Spannung festgestellt werden. Liegt diese über einem leicht zu definierenden Schwellwert, so wird eine Bedienung erfasst bzw. eine Bedienfunktion ausgelöst. Liegt der Finger 18 nicht oberhalb der oberen Elektrode 17 auf der Bedienoberfläche 12 auf, so ist die Spannung an R6 deutlich niedriger und es wird keine Bedienfunktion ausgelöst.

Bei einer bevorzugten Ausgestaltung der Erfindung als Sensorelement-anordnung unter einer Bedienoberfläche weist eine Elektrolumineszenz-Folie der Bedieneinrichtung eine obere und eine untere Elektrode auf, die zur Ansteuerung dienen. Die obere Elektrode dient auch als kapazitives Sensorelement, um das Auflegen eines Fingers auf die Bedienoberfläche oberhalb der Elektrolumineszenz-Folie als Bedienung zu erfassen. Hierzu ist eine geeignete Ansteuer- und Auswerteschaltung vorgesehen, beispielsweise mit Ansteuerung in Vollbrückenschaltung zur Erfassung eines über die obere Elektrode und den Finger abfließenden Sensorstroms.

## Patentansprüche

1. Sensorelement-Anordnung (11) für eine Bedieneinrichtung, wobei unter einer Bedienoberfläche (12) der Bedieneinrichtung eine leitfähige Schicht (17) an einem Träger (15) angeordnet ist als kapazitives Sensorelement zur Erkennung einer Annäherung eines Fingers (18) einer Bedienperson oder eines ähnlichen Gegenstandes, **dadurch gekennzeichnet, dass** der Träger eine Elektrolumineszenz-Folie (15) ist.

2. Sensorelement-Anordnung nach Anspruch 1, **dadurch gekennzeichnet, dass** die leitfähige Schicht (17) als kapazitives Sensorelement auf der Oberseite bzw. der der Bedienoberfläche (12) zugewandten Seite der Elektrolumineszenz-Folie (15) angeordnet ist.

3. Sensorelement-Anordnung nach Anspruch 1 oder 2, **dadurch gekennzeichnet, dass** die leitfähige Schicht (17) eine von zwei Elektrodenschichten auf beiden Seiten der Elektrolumineszenz-Folie (15) zu deren Ansteuerung durch Anlegen einer Spannung ist, wobei sie vorzugsweise ausgebildet bzw. strukturiert ist zur Darstellung unterschiedlicher Zeichen oder Symbole, wobei insbesondere auf der Elektrolumineszenz-Folie mehrere Sensorelemente bzw. voneinander getrennte leitfähige Schichten (17) nebeneinander vorgesehen sind.

4. Sensorelement-Anordnung nach Anspruch 3, **dadurch gekennzeichnet, dass** eine zweite Elektrodenschicht (16) der Elektrolumineszenz-Folie (15), die auf der von der leitfähigen Schicht abgewandten Seite angeordnet ist, über Schaltmittel (S1) mit einer Auswerteschaltung (20, 120) verbunden ist.

5. Sensorelement-Anordnung nach einem der vorhergehenden Ansprüche, **dadurch gekennzeichnet, dass** die leitfähige Schicht (17) bei Annähern eines Fingers (18) oder Gegenstandes, insbesondere bei Auflegen auf die über der leitfähigen Schicht (17) verlaufenden Bedienoberfläche (12), einen Kondensator bzw. eine Kapazität mit dem Finger (18) oder dem Gegenstand bildet.

6. Sensorelement-Anordnung nach einem der vorhergehenden Ansprüche, **gekennzeichnet durch** eine Auswerteschaltung (120) mit einer Stromspiegel-Schaltung und mit einem Sammel-Kondensator (C4) zur Messung des über die leitfähige Schicht (17) als kapazitives Sensorelement abfließenden Stroms zur Auswertung, ob eine Berührung vorliegt.

7. Sensorelement-Anordnung nach einem der Ansprüche 1 bis 5, **gekennzeichnet durch** eine Vollbrückenschaltung in der Ansteuerung und Auswerteschaltung (20) des kapazitiven Sensorelementes (17) zur Umpolung der Spannung an der Elektrolumineszenz-Folie (15).

8. Verfahren zur Auswertung eines kapazitiven Sensorelements einer Sensorelement-Anordnung (11) nach einem der vorhergehenden Ansprüche, **dadurch gekennzeichnet, dass** der Träger eine Elektrolumineszenz-Folie (15) ist.

9. Verfahren nach Anspruch 8, **dadurch gekennzeichnet, dass** ein Sensor-Strom gemessen wird, der über das kapazitive Sensorelement bzw. die leitfähige Schicht (17) bei Annäherung eines Fingers (18) einer Bedienperson oder eines ähnlichen Gegenstandes abfließt, wobei in der Zeit der Sensor-Strom-Messung die Elektrolumineszenz-Folie (15) nicht zum Leuchten angesteuert wird, wobei vorzugsweise die zweite Elektrodenschicht (16) gemäß Anspruch 4 anschlusslos ist.

10. Verfahren nach Anspruch 9, **dadurch gekennzeichnet, dass** eine Auswertung mit einer Stromspiegel-Schaltung (120) durchgeführt wird, wobei bei jeder positiven Flanke einer Betriebsfrequenz bzw. Betriebsspannung der Sensorelement-Anordnung (11) die zweite Elektrodenschicht (16) der Elektrolumineszenz-Folie (15) für kurze Zeit, vorzugsweise einig µ-Sekunden, verzögert an einen Minuspol einer Versorgungsspannung gelegt wird, wobei der während dieser Verzöherungs-Zeit über die leitfähige Schicht (17) und einen möglicherweise angenäherten Finger (18) abfließende Sensor-Strom gemessen wird.

11. Verfahren nach Anspruch 10, **dadurch gekennzeichnet, dass** über die Stromspiegel-Schaltung (120) ein Strom, der vorzugsweise in etwa dem über die leitfähige Schicht (17) abfließenden Sensor-Strom entspricht, zur Erfassung in einen Kondensator (C4) fließt, wobei bei Überschreiten eines bestimmten Schwellwerts dieses Stroms eine Bedienung erkannt und eine Bedienfunktion ausgelöst wird und bei Unterschreiten dieses Schwellwerts keine Bedienung erkannt wird.

12. Verfahren nach Anspruch 11, **dadurch gekennzeichnet, dass** die aufgrund des abfließenden Stroms in dem Kondensator (C4) entstehende Ladung aus dem Kondensator (C4) über einen Widerstand (R6) als Strom abgeleitet wird und die Spannung an dem Widerstand (R6) als Schwellwert verwendet wird bzw. geprüft wird, ob diese Spannung einen Schwellwert überschreitet oder unterschreitet.

13. Verfahren nach Anspruch 8, **dadurch gekennzeichnet, dass** die Elektrolumineszenz-Folie (15) bzw. die Elektrodenschichten (16, 17) im Ausgangszweig einer Vollbrückenschaltung betrieben werden, wobei vorzugsweise die Spannung an der Elektrolumineszenz-Folie (15) umgepolt wird zum Anlegen einer Wechselspannung.

14. Verfahren nach Anspruch 13, **dadurch gekennzeichnet, dass** an die elektrisch leitfähige Schicht (17) eine pulsierende Spannung angelegt wird, wobei der andere Zweig der Brückenschaltung hochohmig oder im Gleichtakt geschaltet ist, und der Sensorstrom gemessen wird, insbesondere **dadurch**, dass in manchen Perioden der Wechselspannung die zweite Hälfte der Brückenschaltung hochohmig oder im Gleichtakt geschaltet wird und die Brückenschaltung mit einer höheren Frequenz betrieben wird.
